(19) Europäisches Patentamt / European Patent Office / Office européen des brevets

(11) **EP 2 450 814 A2**

(12) **EUROPÄISCHE PATENTANMELDUNG**

(43) Veröffentlichungstag:
**09.05.2012 Patentblatt 2012/19**

(51) Int Cl.:
***G06F 17/50*** *(2006.01)*

(21) Anmeldenummer: **11004670.3**

(22) Anmeldetag: **08.06.2011**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **09.11.2010 DE 102010050834**

(71) Anmelder: **Fraunhofer-Gesellschaft zur Förderung der angewandten Forschung e.V.
80686 München (DE)**

(72) Erfinder:
• **Bitsch, Gerd
67663 Kaiserslautern (DE)**

• **Burger, Michael
67663 Kaiserslautern (DE)**
• **Dreßler, Klaus
66879 Kollweiler (DE)**
• **Marquardt, Albert
67657 Kaiserslautern (DE)**
• **Speckert, Michael
67661 Kaiserslautern (DE)**

(74) Vertreter: **Pfenning, Meinig & Partner GbR
Patent- und Rechtsanwälte
Theresienhöhe 13
80339 München (DE)**

(54) **Verfahren zur Erzeugung eines Anregungsprofils und Verfahren zur Bereitstellung von Kräften und Momenten zur Anregung von Kraftfahrzeugen**

(57)    Die Erfindung betrifft ein Verfahren zur zeitabhängigen Bereitstellung zumindest einer Kraft und/oder zumindest eines Momentes zur Wirkung auf eine Nabe eines Kraftfahrzeuges, wobei der Verlauf der Kräfte und/ oder Momente mit einem Ersatzmodel eines Reifens aus einem Anregungsprofil erzeugt wird. Die Erfindung betrifft außerdem ein Verfahren zur Erzeugung eines solchen Anregungsprofiles.

Fig. 1

## Beschreibung

Die Erfindung betrifft ein Verfahren zur zeitabhängigen Bereitstellung zumindest einer Kraft und/oder zumindest eines Momentes zur Wirkung auf eine Nabe eines Kraftfahrzeuges, wobei der Verlauf der Kräfte und/oder Momente mit einem Ersatzmodel eines Reifens aus einem Anregungsprofil erzeugt wird. Die Erfindung betrifft außerdem ein Verfahren zur Erzeugung eines solchen Anregungsprofiles.

Zur betriebsfesten Auslegung von Fahrzeugen werden sowohl Simulationen als auch Versuche an Gesamtfahrzeugen und Teilsystemen durchgeführt. Dabei werden normalerweise Anregungssignale eingesetzt, die Test-oder Kundenstrecken von ca. 15 bis 20 Minuten Dauer repräsentieren.

Zwei Kernbestandteile derartiger Untersuchungen sind:

- Systemmodelle, unterschieden nach Anwendungsfall:

  - Simulation: virtuelle Modelle der Fahrzeugoder Teilsysteme (z.B. Achsen),
  - Versuch/Prüfstand: physikalische Modelle, d.h. reale Fahrzeuge oder Teilsysteme (z.B. Achsen).

- Anregungen, die die Straße repräsentieren.

Nach dem Stand der Technik ist es schwierig bis unmöglich, die komplexe mehrdimensionale dynamische Wechselwirkung zwischen Straße und Reifen in der Simulation oder im Versuch realitätsnah abzubilden. Es sind daher Vereinfachungen notwendig, die sich negativ auf die Vorhersagegüte von Beanspruchungen und somit auf die Ergebnisqualität insgesamt auswirken.

Aus dem Stand der Technik sind im Wesentlichen zwei Verfahren bekannt, um Anregungssignale zu erhalten, die möglichst realitätsnah Belastungen am Fahrzeug reproduzieren. Zum einen können Radkräfte gemessen und anschließend übertragen werden. Dabei werden Radnaben-Kräfte und -Momente mit einem realen Messfahrzeug erfasst, das über eine Teststrecke oder -straße fährt. Diese gemessenen Signale können dann nach geeigneter Aufbereitung direkt an den Radnaben des virtuellen Modells oder des realen Fahrzeugs auf dem Prüfstand aufgebracht werden.

Ein gravierender Nachteil dieses messbasierten Verfahrens ist, dass die Messgrößen (Radkräfte und -momente) fahrzeugabhängig und somit nicht auf andere Fahrzeuge übertragbar sind. Invarianz, d.h. Fahrzeugunabhängigkeit, ist jedoch eine wesentliche Voraussetzung, um Simulationen oder Versuche für Fahrzeuge durchzuführen, für die keine Messungen vorliegen.

Zum anderen können digitale Straßenmodelle eingesetzt werden. Hier wird eine reale Straße optisch/digital vermessen und liegt anschließend in einem Datensatz als dreidimensionales Profil vor. Diese dreidimensionale Straße, also das Profil, kann dann mit einem Simulationsmodell befahren werden. In der Praxis bereitet dieses Verfahren jedoch verschiedene Schwierigkeiten. So sind ausreichend gute mehrdimensionale Reifenmodelle nicht verfügbar oder benötigen so viel Rechenzeit, dass nur sehr kurze Fahrten von wenigen Sekunden berechnet werden können. Andererseits erreichen einfache Reifenmodelle nicht die notwendige Ergebnisgüte hinsichtlich aller sechs Schnittkräfte/-momente an den Naben. Dreidimensionale Straßenprofile für lange Strecken sind nicht verfügbar oder nur sehr teuer zu erfassen. Darüber hinaus ist auch die digitale Straße nicht im Prüfstandumfeld einsetzbar.

Es ist also mit der digitalen Straße derzeit nicht möglich, lange Fahrten mit hoher Vorhersagegüte zu simulieren, da durch die erforderliche Modellkomplexität die Rechenzeit viel zu hoch ist und einfachere Modelle nicht die benötigte Ergebnisqualität liefern.

Aufgabe der vorliegenden Erfindung ist es, ein Verfahren anzugeben, mit dem zeitabhängig Kräfte und/oder Momente auf eine Nabe eines Kraftfahrzeugs bereitstellbar sind, die mit hoher Genauigkeit jene Kräfte und/oder Momente widerspiegeln, die bei einer realen Fahrt eines Fahrzeugs auf die Nabe wirken, wobei das Verfahren mit geringem Rechenaufwand realisierbar sein soll und eine einfache Übertragung auf verschiedene Fahrzeugmodelle erlauben soll.

Diese Aufgabe wird gelöst durch das Verfahren zur Erzeugung eines Anregungsprofiles nach Anspruch 1 und das Verfahren zur zeitabhängigen Bereitstellung zumindest einer Kraft und/oder zumindest eines Momentes nach Anspruch 4. Die jeweiligen abhängigen Ansprüche geben vorteilhafte Weiterbildungen des erfindungsgemäßen Verfahrens an.

Erfindungsgemäß wird die Wirkung zumindest einer Kraft und/oder zumindest eines Momentes auf eine Nabe eines Kraftfahrzeugs mittels eines Ersatzmodelles eines Reifens ermittelt. Dabei bestimmt das Ersatzmodell die Kräfte bzw. die Momente aus einem Anregungsprofil, das einen zeitlichen Verlauf von auf den Reifen eines Kraftfahrzeugs wirkenden mechanischen Größen nachbildet. Es kann also im Wesentlichen das Ersatzmodell als Modell eines Reifens und das Anregungsprofil als Modell einer Straße angesehen werden.

Das Ersatzmodell kann an eine Nabe des Kraftfahrzeugs gekoppelt werden und liefert dann zumindest eine Kraft- und/oder zumindest eine Momentwirkung auf die Nabe. Die Kraft- bzw. Momentwirkung kann dabei in einem Prüfstand erzeugt und auf die Nabe eines Kraftfahrzeugs beaufschlagt werden, es ist aber auch möglich, die ermittelten Kraft- und/oder Momentwirkungen in einer Simulation auf die Nabe eines simulierten Kraftfahrzeugs wirken zu lassen.

Im Folgenden wird unter einer Nabe jener Teil eines Fahrzeugs verstanden, der den Reifen trägt bzw. mit der Achse starr verbunden ist. Man spricht auch vom Radträger. Die beweglichen Teile stellen zusammen den Reifen dar.

Zur Prüfung oder Simulation eines vollständigen Kraftfahrzeugs kann das erfindungsgemäße Verfahren für jede Nabe des Kraftfahrzeugs durchgeführt werden.

Es wird zunächst ein erfindungsgemäßes Verfahren zur Erzeugung eines Anregungsprofils angegeben. Dieses Anregungsprofil bildet den zeitlichen Verlauf von auf einen Reifen eines Kraftfahrzeuges wirkenden mechanischen Größen nach, die eine Kraft- und/oder Momentwirkung des Reifens auf eine Nabe des Kraftfahrzeuges verursachen. Diese auf den Reifen des Kraftfahrzeugs wirkenden mechanischen Größen können u.a. Kräfte, Momente und/oder Verschiebungen des Reifens sein, die beispielsweise durch eine Straße auf den Reifen ausgeübt werden.

Das Anregungsprofil wird erfindungsgemäß so erzeugt, dass mittels eines Ersatzmodelles des Reifens aus dem Anregungsprofil der zeitliche Verlauf zumindest einer Kraft und/oder zumindest eines Momentes zur Wirkung auf die Nabe bestimmbar ist.

Zur Erzeugung des Anregungsprofiles wird ein zeitlicher Verlauf der Kraft- und/oder Momentwirkung des Reifens auf die Nabe bei Wirkung der mechanischen Größen auf den Reifen gemessen und/oder simuliert. Es wird also mit dem Fahrzeug eine reale oder virtuelle Teststrecke befahren, wobei die mechanischen Größen auf den Reifen wirken und eine Kraft- und/oder Momentwirkung auf die Nabe verursachen.

Aus dem gemessenen bzw. simulierten zeitlichen Verlauf der Kraft- und/oder Momentwirkung des Reifens auf die Nabe wird nun ein zeitlicher Verlauf der auf den Reifen wirkenden mechanischen Größen als Anregungsprofil ermittelt.

Das Anregungsprofil, d.h. der zeitliche Verlauf der auf den Reifen wirkenden mechanischen Größen, kann dabei gerade so ermittelt werden, dass, wenn das Ersatzmodell auf das Anregungsprofil angewandt wird, das Ersatzmodell einen zeitlichen Verlauf von Kräften und/oder Momenten auf die Nabe liefert, der mit dem gemessenen Verlauf dieser Kräfte und/oder Momente optimal übereinstimmt, oder besonders bevorzugt mit diesen identisch ist. Es wird also ermittelt, welche mechanischen Größen wie auf das Ersatzmodell wirken müssten, um den gemessenen Verlauf der Kräfte und/oder Momente, die auf die Nabe wirken, optimal oder identisch zu reproduzieren.

Eine derartige Bestimmung des Anregungsprofils kann beispielsweise mittels eines Optimalsteuerungsalgorithmuses, eines direkten Optimalsteuerungsalgorithmuses oder einer Methode der Control-Constraints erfolgen.

Mit Hilfe des so ermittelten Anregungsprofils kann nun zumindest eine Kraft oder zumindest ein Moment zur Wirkung auf die Nabe des Kraftfahrzeugs bereitgestellt werden. Die Kräfte bzw. Momente können dabei auf die Nabe anstelle jener Kräfte oder Momente wirken, die ein Reifen beim Befahren einer Straße auf die Nabe ausüben würde.

Der zeitabhängige Verlauf der zumindest einen Kraft und/oder des zumindest einen Momentes wird dabei mit dem Ersatzmodell des Reifens bestimmt, das aus dem wie vorstehend beschrieben bestimmten Anregungsprofil die entsprechende Kraft und/oder das entsprechende Moment auf die Nabe erzeugt. Das Ersatzmodell kann hierbei als eine oder mehrere Funktionen angesehen werden, die auf die durch das Anregungsprofil gegebenen mechanischen Größen wirken und als Funktionswerte die entsprechenden Kräfte bzw. Momente auf die Nabe ergeben. Eingangsgrößen des Ersatzmodelles können also das Straßenprofil und die Bewegung der Nabe sein, Ausgangsgrößen können die auf die Nabe wirkenden Kräfte und Momente sein.

Zur nummerischen Berechnung kann die Zeit diskretisiert werden, so dass das Anregungsprofil die entsprechenden mechanischen Größen zu bestimmten Zeitpunkten bereitstellt und das Ersatzmodell die auf die Nabe wirkenden Kräfte bzw. Momente zu diesen Zeitpunkten erzeugt. Der Vorteil der Ermittlung der Kräfte und/oder Momente auf die Nabe über das Ersatzmodell aus dem Anregungsprofil besteht vor allem darin, dass die Ermittlung weitgehend fahrzeugunabhängig ist. Hat man also ein Ersatzmodell und ein Anregungsprofil mittels eines Referenzfahrzeugs bestimmt, so kann das gleiche Ersatzmodell und das gleiche Anregungsprofil ohne weiteres auf andere Fahrzeuge übertragen werden.

Erfindungsgemäß kann die zumindest eine Kraft und/oder das zumindest eine Moment in einem Prüfstand für ein Kraftfahrzeug bereitgestellt und erzeugt werden. Die entsprechenden Kräfte bzw. Momente wirken also dann tatsächlich auf die Nabe eines realen Kraftfahrzeugs, so dass dessen Verhalten untersucht werden kann. Selbstverständlich können die durch das Ersatzmodell ermittelten Kräfte und/oder Momente auch einer Simulation eines Kraftfahrzeugs zugrunde gelegt werden. Sie wirken hierbei also auf die Naben des simulierten Kraftfahrzeugs.

Vorteilhafterweise haben die auf die Nabe wirkenden Kräfte und/oder Momente, die durch das Ersatzmodell bereitgestellt werden, jeweils drei Translationsanteile und drei Rotationsanteile. Die drei Translationsanteile können also drei Kräfte und die drei Rotationsanteile drei Momente sein. Auf diese Weise können Kraft- bzw. Momentwirkungen in allen Freiheitsgraden der Nabe bereitgestellt und berücksichtigt werden.

Vorteilhafterweise weist das Ersatzmodell ein mechanisches Mehrkörpersystem auf oder ist ein solches. Dieses mechanische Mehrkörpersystem wird mit der Nabe gekoppelt, so dass es Kräfte und/oder Momente auf die Nabe ausüben kann. Andererseits können die mechanischen Größen, die durch das Anregungsprofil bereitgestellt werden, auf dieses mechanische Mehrkörpersystem wirken, so dass das mechanische Mehrkörpersystem die entsprechenden Kräfte und/oder Momente auf die Nabe ausübt.

In einer vorteilhaften Ausgestaltung der Erfindung weist das mechanische Mehrkörpersystem für zumindest einen Freiheitsgrad des Ersatzmodelles einen Mehr-Massen-Schwinger auf, der zwei oder mehr Massen aufweist, die über jeweils ein elastisches Element miteinander verbunden sind. Dieser Mehr-Massen-Schwinger kann also in dem entsprechenden Freiheitsgraden eine Kraft bzw. ein Moment auf die Nabe ausüben. Das Anregungsprofil kann für jeden Freiheitsgrad die entsprechenden mechanischen Größen bereitstellen, die auf den entsprechenden Mehr-Massen-Schwinger wirken, um durch diesen die entsprechende Kraft bzw. das entsprechende Moment auf die Nabe auszuüben. Bevorzugterweise sind die entsprechenden Mehr-Massen-Schwinger mit einem Ende oder auch mit einer Masse fest mit der Nabe verbunden.

Grundsätzlich kann der Mehr-Massen-Schwinger eine beliebige Anzahl von Massen aufweisen. Es lassen sich jedoch mit einem Zwei-Massen-Schwinger bereits sehr gute Ergebnisse bei minimalem Rechenaufwand erzielen. Es ist also vorteilhaft, wenn der Mehr-Massen-Schwinger gerade zwei Massen aufweist.

Die beschriebenen elastischen Elemente sind in allen Ausführungsformen vorzugsweise gedämpft. In einer vorteilhaften Ausgestaltung können die elastischen Elemente zumindest eine Feder und zumindest ein Dämpfungselement aufweisen, die besonders bevorzugt parallel zueinander wirkend angeordnet sind. Es können also hierbei die entsprechende Feder und das entsprechende Dämpfungselement an beiden Enden fest miteinander verbunden sein.

Für besondere Einsatzgebiete können auch komplexere Ersatzmodelle zum Einsatz kommen. So kann beispielsweise ein Mehr-Massen-Schwinger im vorstehend beschriebenen Sinne eine die Nabe ringförmig umgebende Masse aufweisen, die mit der Nabe über zumindest zwei elastische Elemente verbunden ist. In einem solchen Ersatzmodell wären also verschiedene Dimensionen gekoppelt. Eine vertikale Wirkung des Anregungsprofils würde hier sowohl eine Vertikal- als auch eine Längskraft, also eine horizontale Kraft, erzeugen.

Auch hier können die elastischen Elemente wie vorstehend beschrieben mit Federn und Dämpfungselementen ausgestaltet sein.

Eine weitere Annäherung an das Verhalten eines realen Reifens lässt sich durch ein Ersatzmodell erzielen, in dem ein Mehr-Massen-Schwinger zwei, drei oder mehr parallel wirkende elastische Elemente aufweist, auf welche die durch das Anregungsprofil gegebenen mechanischen Größen parallel und zeitlich versetzt wirken. Da das Anregungsprofil das Abfahren einer Strecke widerspiegelt, entspricht jeder Zeitpunkt des Anregungsprofils einem bestimmten Ort auf der Strecke. Auf dieser virtuellen Strecke können die mechanischen Größen so zeitlich versetzt auf die parallelen elastischen Elemente wirken, dass innerhalb des zeitlichen Versatzes zwischen zwei der elastischen Elemente das Fahrzeug den Abstand zwischen den elastischen Elementen als Weg zurückgelegt hätte. Auf diese Weise kann der Reifenlatsch, d.h. die Reifenfläche, die in Kontakt mit der Straße ist, besonders gut modelliert werden.

Das erfindungsgemäße Verfahren erlaubt es, schnell, effizient und zuverlässig invariante Anregungssignale in einer beliebigen Anzahl von Dimensionen pro Reifen direkt zu ermitteln. Diese sind mit hoher Produktionsgüte und Invarianz, d.h. Fahrzeugunabhängigkeit, auf andere Fahrzeugvarianten übertragbar und im Versuch wie auch in Simulationen einsetzbar.

Im Folgenden soll die Erfindung anhand einiger Beispiele näher erläutert werden. Dabei wird auf die folgenden Figuren Bezug genommen. In diesen bezeichnen gleiche Bezugszeichen gleiche oder analoge Merkmale. Alle in den Beispielen beschriebenen Merkmale können auch unabhängig vom konkreten Beispiel realisiert werden.

Es zeigt

Figur 1    ein Beispiel eines prinzipiellen Ablaufs des erfindungsgemäßen Verfahrens;

Figur 2    einen beispielhaften Ablauf des erfindungsgemäßen Verfahrens;

Figur 3    eine beispielhafte Ausführung des erfindungsgemäßen Verfahrens in einer Simulation;

Figur 4    Kräfte, die sich aus einem erfindungsgemäßen Anregungsprofil ergeben, zur Verifikation;

Figur 5    Momente, die sich aus einem erfindungsgemäßen Anregungsprofil ergeben;

Figur 6    Kraftverläufe, die sich durch Anwendung eines erfindungsgemäß ermittelten Anregungsprofils auf ein anderes Fahrzeug ergeben;

Figur 7    Nabenmomente, die sich durch Anwendung eines erfindungsgemäß ermittelten Anregungsprofils auf ein anderes Fahrzeug ergeben;

Figur 8    Nabenkräfte, die sich durch Anwendung eines erfindungsgemäß ermittelten Anregungsprofils auf ein weiteres Fahrzeugmodell ergeben;

Figur 9    Nabenmomente, die sich durch Anwendung eines erfindungsgemäß erzeugten Anregungsprofils auf ein weiteres Fahrzeugmodell ergeben;

Figur 10    Nabenkräfte, die sich durch Anwendung eines erfindungsgemäß erzeugten Anregungsprofils auf ein weiteres Fahrzeugmodell ergeben;

Figur 11    Nabenmomente, die sich durch Anwendung eines erfindungsgemäß erzeugten Anregungsprofils auf ein weiteres Fahrzeugmodell ergeben;

Figur 12    ein Beispiel eines eindimensionalen ZweiMassen-Schwingers, der erfindungsgemäß im Ersatzmodell einsetzbar ist;

Figur 13    ein Beispiel einer Nabe mit drei ZweiMassen-Schwingern für die translatorischen Freiheitsgrade;

Figur 14    ein Beispiel einer Nabe mit drei rotatorischen Zwei-Massen-Schwingern für drei Rotations-Freiheitsgrade;

Figur 15    ein Ring-Modell als Reifen-Ersatzmodell; und

Figur 16    ein Ersatzmodell mit Modellierung des Reifenlatsches.

Im Folgenden soll das erfindungsgemäße Verfahren anhand eines ersten Beispiels dargestellt werden. Dabei wird von einem Referenzfahrzeug ausgegangen, für das radnabenbezogene Größen aus Messung oder Simulation vorliegen. Dieses Referenzfahrzeug wird an der Radnabe freigeschnitten. An der Radnabe liegen alle relevanten dynamischen Größen, wie Kräfte, Momente und Bewegungen vor.

Es wird nun ein dynamisches Teilmodell zusammen mit einer sechsdimensionalen Eingangsgröße eingeführt, das das Reifenverhalten abbildet. Dieses wird im folgenden Reifen/Anregungsmodell genannt. Das dynamische Teilmodell ist hierbei ein Ersatzmodell für den Reifen.

Das Ersatzmodell wird dann mit der Radnabe des Fahrzeugs verbunden. Mit Hilfe des Ersatzmodells wird nun beispielsweise mittels Optimalsteuerungsmethoden aus den gemessenen bzw. simulierten Radnabengrößen auf ein invariantes Anregungsprofil zurückgerechnet, was ohne Iteration erfolgen kann.

Das kombinierte sechsdimensionale Reifen/Anregungsmodell, d.h. das Paar aufweisend das Ersatzmodell sowie das Anregungsprofil, kann nun auf andere Fahrzeuge übertragen werden. Das Reifen/Anregungsmodell kann sowohl zur Anregung von Fahrzeugen im Prüfstandsversuch wie auch in der Simulation verwendet werden.

Das Reifen/Anregungsmodell ist ein dynamisches System, das das Fahrbahn-Reifenverhalten approximieren kann. Es enthält in diesem Beispiel als Bestandteile zum einen einen starren Körper, der mit der Fahrzeugnabe verbunden wird, und zum anderen eine sechsdimensionale Eingangsgröße, nämlich das Anregungsprofil.

Zwischen diesen beiden Bestandteilen befindet sich das (dynamische) Ersatzmodell, das die Eigendynamik des Reifens abbildet und Kräfte und Momente auf den Nabenkörper überträgt. Der starre Körper, der mit der Fahrzeugnabe verbunden wird, kann dabei als Teil des Ersatzmodelles angesehen werden. Das Ersatzmodell und das Anregungsprofil gehören hierbei zusammen. Ein Anregungsprofil wird also unter Verwendung eines bestimmten Ersatzmodelles ermittelt.

Das Reifen-Ersatzmodell und das Anregungsprofil sind als Paar (bis zu einem gewissen Grad) Fahrzeugunabhängig und können auf andere Fahrzeuge übertragen werden.

Ein Beispiel eines solchen Ersatzmodelles ist ein sechsdimensionaler, linearer Zwei-Massen-Schwinger, dessen obere Masse mit der Nabe gekoppelt ist. Sechsdimensional bedeutet dabei, dass jeweils ein linearer Zwei-Massen-Schwinger in den drei translatorischen Dimensionen (x, y und z, beispielsweise eine Translationsfeder) und jeweils ein rotatorischer Zwei-Massen-Schwinger in den drei rotatorischen Dimensionen (beispielsweise dargestellt durch Kardan-Winkel) vorgesehen ist. Für die rotatorischen Dimensionen kann beispielsweise eine Torsionsfeder zum Einsatz kommen.

Das sechsdimensionale Anregungsprofil ist hierbei die Verschiebung bzw. Verdrehung am untersten Punkt, d.h. am der Nabe abgewandten Ende des entsprechenden Ersatzmodells, den man physikalisch als Reifenaufstandspunkt interpretieren kann.

Das Anregungsprofil wird nun beispielsweise mittels Optimalsteuerungsalgorithmen auf Basis der gemessenen bzw. simulierten Radnabengrößen (beispielsweise Schnittkräfte/Momente und Bewegungen) ermittelt, d.h. es wird so berechnet, dass sich bei einer Simulation oder Messung des Reifen/Anregungsmodells mit diesem Anregungsprofil die besagte Referenzgröße an der Radnabe bzw. an dem mit ihr identifizierten Körper möglichst gut einstellt. Hierbei wird nur das Reifen/- Anregungsmodell zusammen mit den Schnittgrößen an der Nabe betrachtet.

Mathematisch lässt sich dieses Problem als Optimalsteuerungsproblem formulieren und erlaubt die Verwendung von erprobten Algorithmen aus der Optimalsteuerungstheorie. Je nach verwendetem Ersatzmodell bieten sich verschiedene Verfahren an.

Es kann beispielsweise die Methode der Control-Constraints für Ersatzmodelle von mittlerer Komplexität verwendet werden. Es können hier sechs Referenzgrößen verwendet werden, die den sechs Eingangsgrößen entsprechen.

Alternativ können für komplexere Reifenmodelle mit unter Umständen mehr als sechs Referenzgrößen auch sog. Direkt-Optimalsteuerungsalgorithmen eingesetzt werden.

Das Ersatzmodell fließt auch in die Ermittlung des Anregungsprofils ein. Im Folgenden soll das bei der Ermittlung des Anregungsprofils eingesetzte Ersatzmodell auch als inverses Ersatzmodell bezeichnet werden.

Wird ein Anregungsprofil wie vorstehend beschrieben ermittelt, lässt sich das Reifen/Anregungsmodell, d.h. das Paar aus dynamischem Ersatzmodell und berechnetem sechsdimensionalem Anregungsprofil, übertragen, um damit andere an der Nabe freigeschnittene Ganzfahrzeugmodelle zu vermessen oder zu simulieren.

Bei einer Simulation werden dabei Schnittgrößen des an der Radnabe freigeschnittenen Fahrzeugs, also drei Kräfte und drei Momente, während der Simulation vom Reifen/Anregungsmodell an die Nabe übertragen. Dazu wird die Simulation des Reifen/Anregungsmodells (Reifen-Ersatzmodell mit Anregungsprofil) entsprechend in den Simulationsprozess des restlichen Fahrzeugmodells integriert.

Im Komponentenversuch wird jener Teil des Systems, der nicht als Hardware vorliegt, mittels echtzeitfähigen Ersatzmodellen und dazu passenden Anregungszeitreihen online mitberechnet, so dass die Prüfstandsregelalgorithmen mit fahrzeugunabhängigen Stellgrößen arbeiten können. Zum Beispiel kann ein nabengekoppelter Achsprüfstand, der physikalisch auf Radkräfte regelt, mit einem sechsdimensionalen Reifen-Ersatzmodell gekoppelt werden. Das virtuelle Verschiebungsprofil wird hierbei als Soll-Größe gegeben. Die Ist-Verschiebung wird dabei online durch das inverse Ersatzmodell wie beschrieben berechnet.

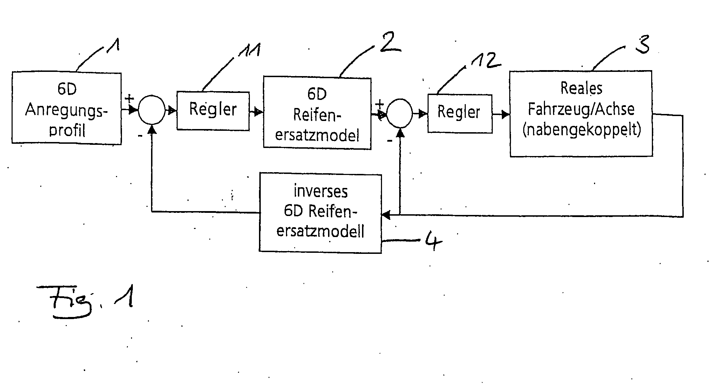

Figur 1 zeigt das Vorgehen im Versuch. Dabei wird im vorliegenden Beispiel von einem sechsdimensionalen Anregungsprofil 1 ausgegangen. Über einen Regler 11 ermittelt ein sechsdimensionales Reifen-Ersatzmodell 2 Kräfte und/oder Momente, die über einen Regler 12 nabengekoppelt auf ein reales Fahrzeug 3 bzw. dessen Achse weitergegeben werden. Über ein inverses sechsdimensionales Reifen-Ersatzmodell 4 kann ausgehend von dem Fahrzeug 3 zurückberechnet werden, welcher Verschiebung im Anregungsprofil die tatsächlichen Kräfte, Momente und Verschiebungen an der Nabe des Fahrzeugs entsprechen würden.

In einem Versuch kann das erfindungsgemäße Verfahren beispielsweise eingesetzt werden, indem das Reifen/-Anregungsmodell als echtzeitfähiges Modulationsmodell in die Prüfstandsumgebung integriert wird ("model-inthe-loop"). Auf diese Weise kann die hohe Reproduktionsgüte nabengekoppelter Prüfstände mit der Verwendung fahrzeugunabhängiger Signale vereint werden.

In einer Simulation kann das Reifen/Anregungsmodell mit bisher üblichen Mehrkörpersimulations- oder Finite-Elemente-Ganzfahrzeugmodellen oder Teilmodellen (z.B. Achsen) gekoppelt werden. Durch das erfindungsgemäße Reifen/Anregungsmodell können Belastungen, die aus dem Überfahren eines Untergrunds herrühren, in das Fahrzeug eingebracht werden. Das erfindungsgemäße Verfahren ermöglicht es, lang dauernde Fahrten von bis zu mehreren Stunden Realzeit bei gleichzeitig hoher Vorhersagegüte hinsichtlich der Fahrzeugbeanspruchungen zu simulieren, was in bisherigen Verfahren nicht möglich war.

Im Folgenden soll ein Beispiel für das erfindungsgemäße Vorgehen gegeben werden.

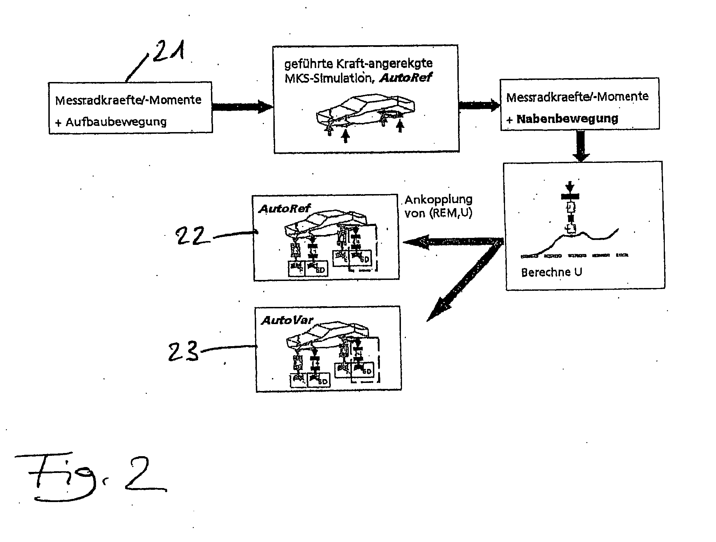

Das Vorgehen ist graphisch in Figur 2 dargestellt. Ausgegangen wird von gemessenen Radkräften und -momenten sowie Aufbaubewegungen 21. Die Reifenkräfte, Momente und Aufbaubewegungen bilden auf den Reifen wirkende mechanische Größen. Mit diesen kann ein Mehrkörpersystemmodell des Messfahrzeugs, das im Folgenden als AutoRef bezeichnet wird, simuliert werden. Da diese gemessenen Größen stark vom konkreten Fahrzeug abhängen, können Varianten des Messfahrzeugs, beispielsweise mit anderen Fahrzeugparametern, nicht auf Basis der gemessenen Kräfte und Momente simuliert werden.

Als Ergebnis dieser Simulation oder Messung erhält man die Nabenbewegungen an allen vier Naben des Kraftfahrzeugs. Diese werden zusammen mit den Reifenkräften und -momenten verwendet, um das effektive Anregungsprofil U zu berechnen.

Eine invariante Anregung ist nun durch das Paar aus Reifen-Ersatzmodell (REM), auch Ersatzmodell genannt, und dem effektiven Profil U gegeben. Bezeichnet man die invariante Anregung als I6D, so ist also I6D = (REM, U).

Die invariante Anregung wird nun

1. an das Modell des Messfahrzeugs AutoRef gekoppelt und dann simuliert (Schritt 22). Dabei sollen die gemessenen Kräfte reproduziert werden. Zur Verifikation des Verfahrens können also die aus der invarianten Anregung bestimmten Kräfte mit den gemessenen Kräften verglichen werden.

2. Die invariante Anregung wird dann an neue Fahrzeugvarianten AutoVar gekoppelt, für die keine gemessenen Signale vorliegen, die dann aber mit Hilfe der invarianten Anregung I6D simuliert und analysiert werden können (Schritt 23).

Im vorliegenden Beispiel wurde eine virtuelle Messung per Simulation durchgeführt. Das Verfahren ist aber vollständig analog durchführbar mit am realen Fahrzeug gemessenen Kräften und Momenten.

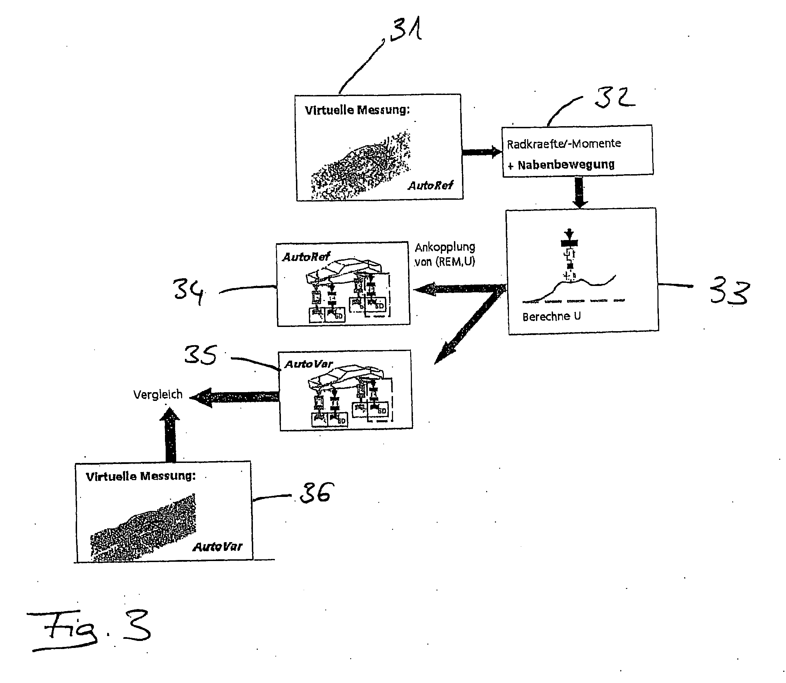

Figur 3 zeigt das Vorgehen bei der virtuellen Messung mittels einer Simulation. Dabei wird an einem Referenzfahrzeug AutoRef zunächst eine virtuelle Messung 31 durchgeführt. Diese könnte auch an einem realen Fahrzeug vorgenommen werden. Aus dieser werden Radkräfte und -momente sowie die Nabenbewegung ermittelt 32. Aus diesen kann dann das Anregungsprofil U berechnet werden 33. Wird nun das berechnete Anregungsprofil U auf das entsprechende Ersatzmodell REM angewandt und die dadurch bestimmten Kräfte und Momente auf die Nabe an das Referenzfahrzeug angekoppelt 34, so sollten die gemessenen Kräfte und Momente möglichst gut reproduziert werden.

Das Ersatzmodell REM und das Anregungsprofil U können dann auf andere Fahrzeuge übertragen werden 35. Zur Bestimmung der Übertragbarkeit des Ersatzmodelles REM und des Anregungsprofils U kann ein Vergleich mit einer realen oder simulierten Messung der Kräfte am neuen Fahrzeug AutoVar 36 durchgeführt werden und die Ergebnisse mit der Berechnung 39 aus dem Ersatzmodell verglichen werden.

Die einzelnen Schritte des Vorgehens sollen im Folgenden im Detail beschrieben werden. Dabei ist:

Schritt 1: virtuelle Messung mit dem Referenzmodell AutoRef 31,

Schritt 2: Berechnung des Anregungsprofils U 33,

Schritt 3: Die Methodenverifikation, wozu die invariante Anregung I6D auf das Referenzmodell AutoRef angewandt wird 34, und

Schritt 4: Die Invarianzanalyse, bei der die invariante Anregung I6D an andere Fahrzeugvarianten AutoVar angekoppelt wird 35 und simuliert wird. Die Ergebnisse können dann mit einer virtuellen oder realen Messung 36 verglichen werden.

Virtuelle Messung

Im praxisrelevanten Anwendungsfall hat man typischerweise an einem Messfahrzeug gemessene Radkräfte und -momente an allen vier Reifen. Bei diesen gemessenen Signalen handelt es sich um Kräfte und Momente, die während der Messfahrt vom realen Reifen auf die Fahrzeugnaben wirken.

Mit diesen gemessenen Signalen wird ein zum Messfahrzeug passendes Mehrkörpersystem(MKS)-Modell angeregt und simuliert. Bei dieser sog. Kraft-angeregten MKS-Simulation erhält man als Ergebnis an allen vier Radnaben die zu den Kräften und Momenten passenden Radnabenbewegungen 32 (Translation und Rotation), die zur Berechnung 33 des effektiven Anregungsprofils zusammen mit den gemessenen Kräften und Momenten herangezogen werden.

Für dieses Beispiel wurden hier keine gemessenen Kräfte und Momente verwendet, sondern eine sog. virtuelle Messung durchgeführt. Das zuvor beschriebene Vorgehen wird dadurch wie folgt modifiziert: Das Fahrzeug-Modell wird zusätzlich mit einem komplexen Reifenmodell ausgestattet. Mit diesem wird dann die Überfahrt über eine digitalisierte Test-Strecke simuliert. Diese Simulation ersetzt die Messung und die anschließende Kraft-angeregte Simulation wie vorstehend beschrieben. Man erhält die Kräfte und Momente sowie die Bewegungen an den Radnaben 32.

Eine virtuelle Messung als Grundlage zu verwenden, schließt Modellierungsunsicherheiten bezüglich eines realen Messfahrzeuges aus und ermöglicht so eine durch Mess- und Modellierungsfehler unbeeinträchtigte Validierung des Verfahrens.

Berechnung des effektiven Anregungsprofils

Mithilfe der in der virtuellen Messung erhaltenen Referenz-Signale wird nun ein sechsdimensionales effektives Anregungsprofil berechnet.

Verifikation des Verfahrens

Das effektive Anregungsprofil U wird zur Verifikation zusammen mit dem Reifen-Ersatzmodell REM an das gleiche Fahrzeug-Modell gekoppelt 34, das für die virtuelle Messung benutzt wurde; letzteres natürlich ohne das komplexe Reifenmodell.

Bei der anschließend durchgeführten Simulation sollten die resultierenden Radkräfte und -momente diejenigen aus der virtuellen Messung reproduzieren.

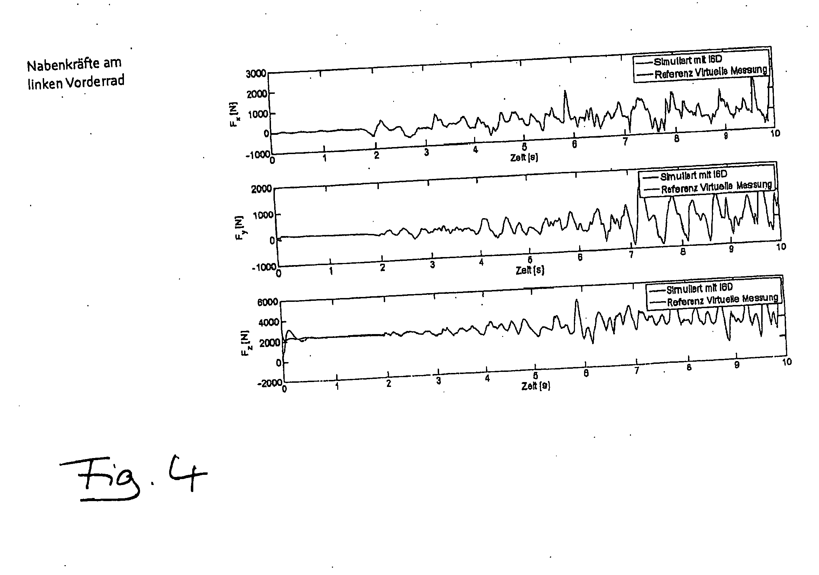

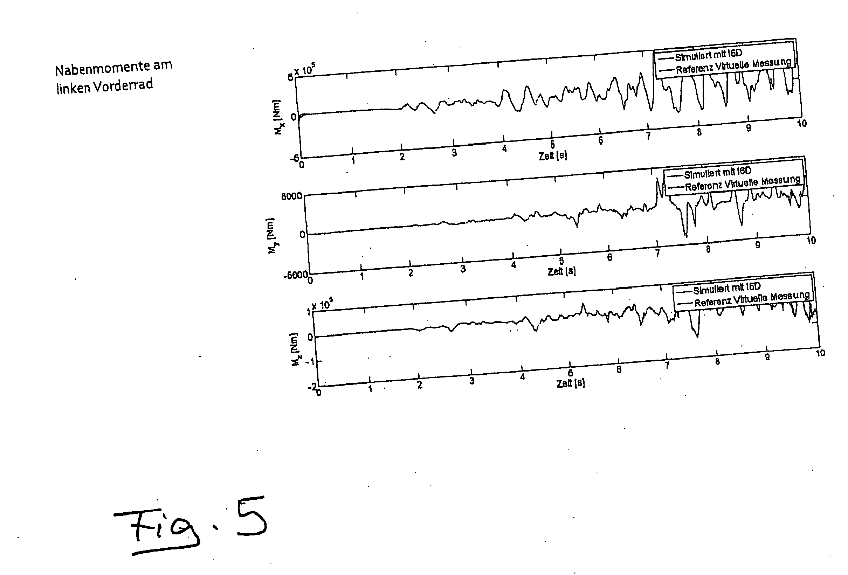

In den Figuren 4 und 5 ist zu erkennen, dass diese Anforderung sehr gut erfüllt wird. Es zeigt dabei Figur 4 Nabenkräfte an einem linken Vorderrad des Fahrzeugs und Figur 5 Nabenmomente am linken Vorderrad jeweils für die Kräfte bzw. Momente in x-Richtung (erste Zeile), y-Richtung (zweite Zeile) und z-Richtung (dritte Zeile). Es ist zu erkennen, dass die gemessenen Kräfte und Momente beinahe exakt reproduziert werden.

Invarianzanalyse

Im Folgenden wird nun gezeigt, dass sich das vorstehend berechnete effektive Anregungsprofil zusammen mit dem zu seiner Berechnung verwendeten Reifen-Ersatzmodell sehr gut auf andere Fahrzeugvarianten übertragen lässt. Zum Vergleich wird mit diesen Fahrzeugvarianten eine virtuelle Messung, also eine Simulation mit einem komplexen Reifenmodell, über die digitalisierte Teststrecke durchgeführt. Die so erhaltenen Kräfte und Momente dienen zum Vergleich und zeigen die Simulationsgüte der Anregung mit dem Reifen-Ersatzmodell REM und dem effektiven Anregungsprofil U.

Die Invarianzanalyse wird im Folgenden für drei Varianten des Referenzfahrzeugs durchgeführt, die aus dem Referenzfahrzeug, das für die erste Messung verwendet wurde, wie folgt hervorgehen:

- AutoRef: Referenzfahrzeug,
- AutoVar1: Erhöhung von Aufhängungssteifigkeiten um 30 %,
- AutoVar2: Erniedrigung der Aufbausteifigkeiten um 50 %, Aufbau-Masse um 100 kg,
- AutoVar3: Erhöhung der Aufbausteifigkeiten um 50 %, Aufbau-Masse um 100 kg.

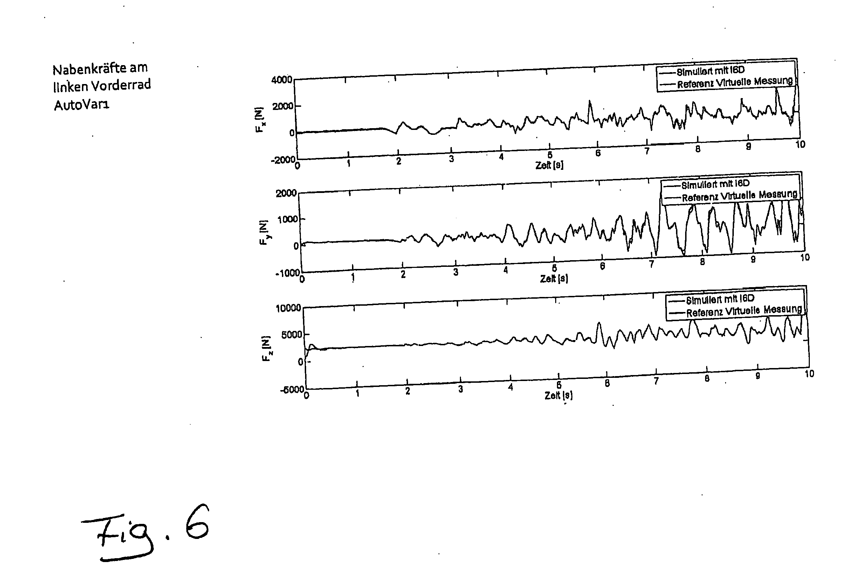

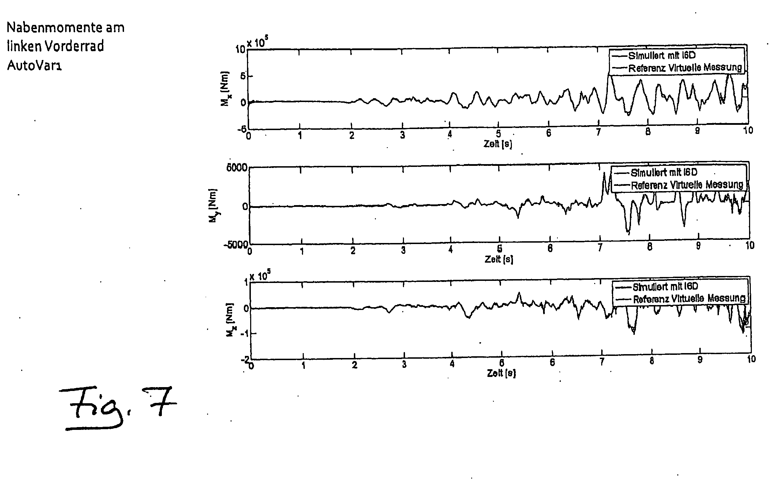

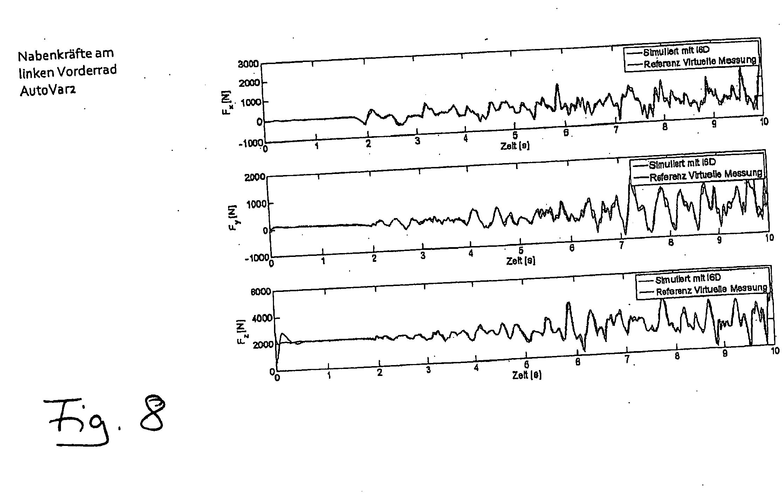

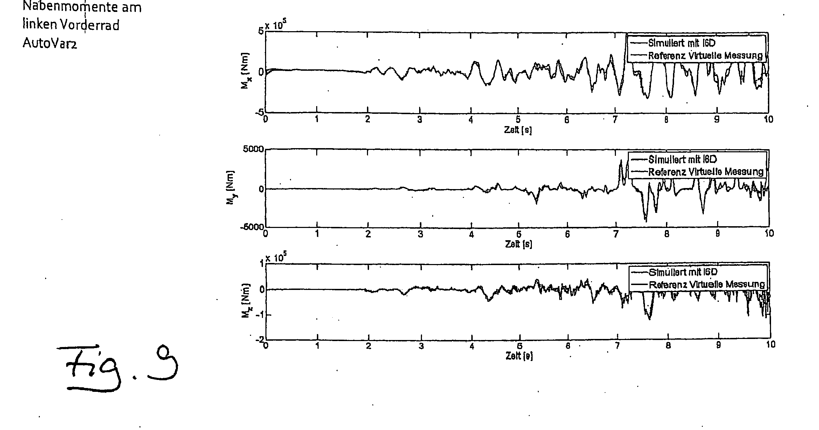

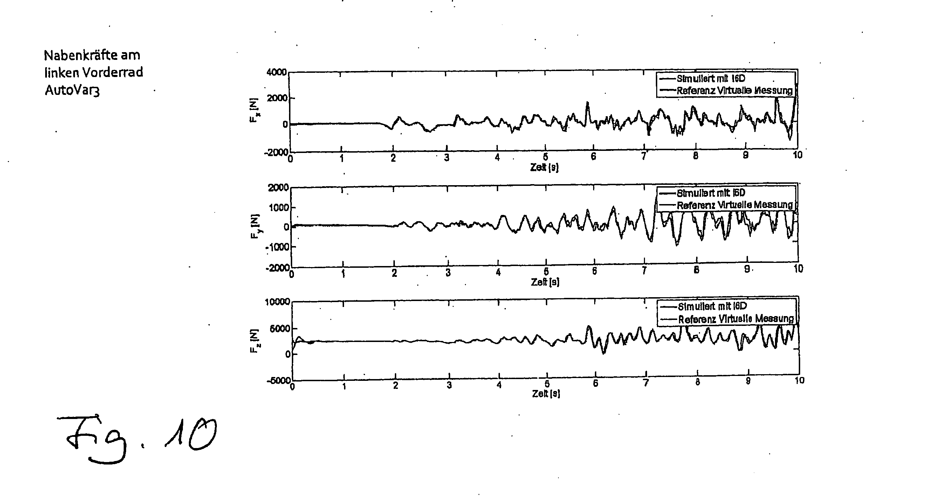

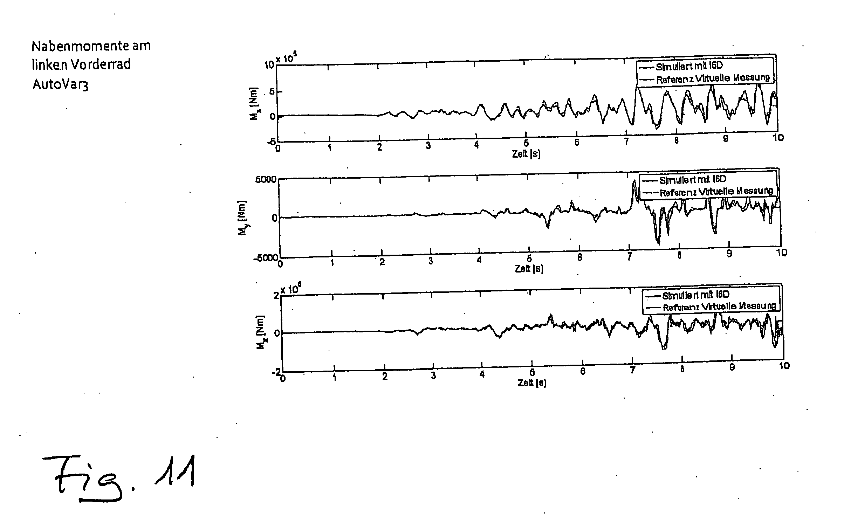

Die Figuren 6, 7, 8, 9, 10 und 11 zeigen die Ergebnisse der Invarianzanalyse. Dabei wird in allen Fällen das linke Vorderrad betrachtet. Figur 6 zeigt dabei die Nabenkräfte im Falle AutoVar1, Figur 7 zeigt die Nabenmomente im Falle AutoVar1, Figur 8 zeigt die Nabenkräfte im Falle AutoVar2, Figur 9 zeigt die Nabenmomente im Falle AutoVar2, Figur 10 zeigt die Nabenkräfte im Falle von AutoVar3 und Figur 11 zeigt die Nabenmomente im Falle von AutoVar3. In allen Fällen werden für eine Zeit von 10 Sekunden die Radnabenkräfte und -momente betrachtet. Es zeigt jeweils die erste Zeile die x-Komponente, die zweite Zeile die y-Komponente und die dritte Zeile die z-Komponente. Es ist deutlich zu erkennen, dass in allen Fällen die gemessenen Werte durch das Anregungsprofil und das Reifen-Ersatzmodell sehr reproduziert werden können.

Im Folgenden sollen einige Beispiele für mögliche Reifen-Ersatzmodelle beschrieben werden. Das Reifen-Ersatzmodell sollte vorteilhaft das dynamische Verhalten eines Reifens in ausreichender Qualität abbilden. In den gezeigten Beispielen ist das Ersatzmodell ein mechanisches Mehrkörpersystem, im Folgenden MKS abgekürzt.

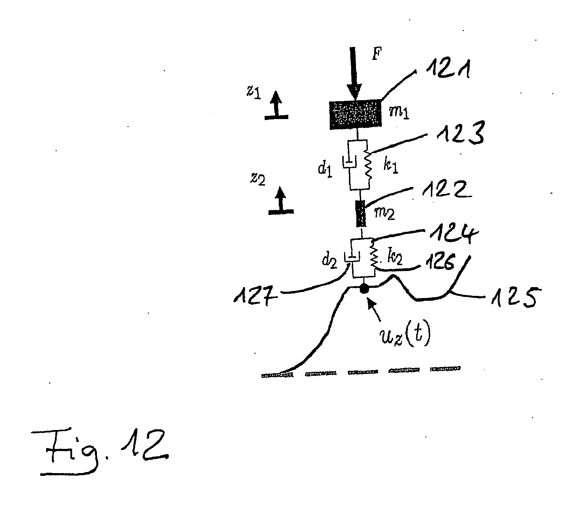

Figur 12 zeigt einen eindimensionalen Zwei-Massen-Schwinger beispielhaft für eine vertikale Richtung, auf dem aufbauend das Ersatzmodell gebildet sein kann. Eine Masse 121 des Zwei-Massen-Schwingers ist mit einer Radnabe des entsprechenden Fahrzeugs fest verbunden oder entspricht der Radnabe. Über ein elastisches Element 123 ist hiermit eine Masse 122 verbunden. Diese wiederum ist mit einem weiteren elastischen Element 124 verbunden, das seinerseits mit einem Anregungsprofil 125 gekoppelt ist.

Die elastischen Elemente 123 und 124 werden hierbei jeweils aus parallel wirkenden Federn 126 und Dämpfungselementen 127 gebildet.

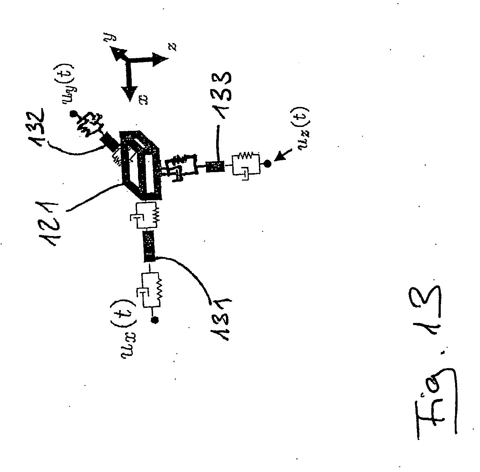

Das Anregungsprofil 125 beaufschlagt nun jenes mit dem Anregungsprofil 125 verbundende Ende des elastischen Elementes 124 mit unterschiedlichen Auslenkungen $u_z(t)$. Dadurch wirkt über das elastische Element 124 eine Kraft und Verschiebung auf die Masse 122. Diese Kraft und Verschiebung wird durch das elastische Element 123 auf die Nabe 121 übertragen. Figur 13 zeigt nun den translatorischen Teil eines Ersatzmodelles mit drei translatorischen eindimensionalen Zwei-Massen-Schwingern 131, 132 und 133. Die Zwei-Massen-Schwinger 131, 132 und 133 entsprechen jenen in Figur 12 gezeigten. Sie wirken auf eine gemeinsame Masse 121, die mit der Nabe des Kraftfahrzeugs verbunden ist oder Teil der Nabe ist.

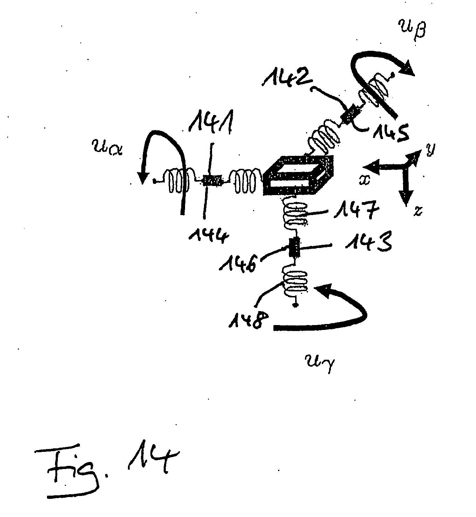

Figur 14 zeigt den rotatorischen Teil eines Ersatzmodelles mit drei rotatorischen Zwei-Massen-Schwingern 141, 142 und 143. Jeder der rotatorischen Zwei-Massen-Schwinger 141, 142 und 143 weist eine Masse 144, 145 bzw. 146 auf, die jeweils zwischen zwei Drehfedern 147, 148 eingespannt sind. Jeweils ein Ende des entsprechenden rotatorischen Zwei-Massen-Schwingers 141, 142 und 143 ist mit der Nabe 121 bzw. einer mit der Nabe gekoppelten Masse 121 gekoppelt. Das jeweils andere Ende wird an das Anregungsprofil U gekoppelt, das die rotatorischen Zwei-Massen-Schwinger mit Momenten bzw. Drehungen beaufschlagt.

Der in Figur 13 gezeigte Teil des Ersatzmodells und der in Figur 14 gezeigte Teil bilden zusammen ein sechsdimensionales Ersatzmodell, das sechs Eingangsgrößen, nämlich x, y und z als Translationen und α, β und y als Rotationen aufweist. Im erfindungsgemäßen Verfahren wird zu einem solchen Ersatzmodell ein sechsdimensionales Anregungsprofil

$$U := (u_x, u_y, u_z, u_\alpha, u_\beta, u_\gamma) \in \mathbb{R}^6 \tag{1.1}$$

ermittelt.

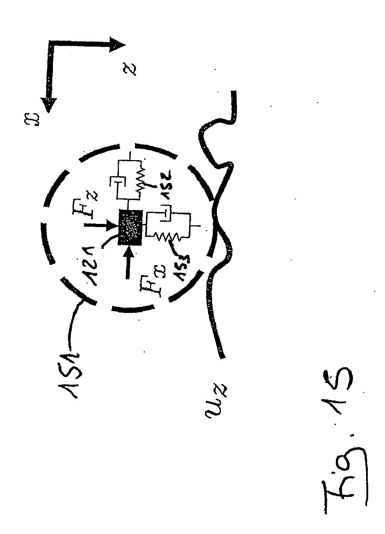

Figur 15 zeigt ein weiteres alternatives Ersatzmodell, bei dem verschiedene Dimensionen gekoppelt sind. Bei dem in Figur 15 gezeigten Modell sind x-Richtung und z-Richtung so gekoppelt, dass eine Anregung in z-Richtung durch das Anregungsprofil sowohl eine in z-Richtung wirkende Kraft wie auch eine in x-Richtung wirkende Kraft erzeugt. Im in Figur 15 gezeigten Anregungsmodell wird die Nabe 121 durch eine ringförmige Masse 151 umgeben, die über zwei elastische Elemente 152 und 153, die in x- bzw. z-Richtung wirken, mit der Nabe 121 bzw. der mit einer Nabe verbundenen Masse 121 gekoppelt ist. Auch hier sind die elastischen Elemente wieder aus jeweils einer Feder und einer parallel zu dieser wirkenden Dämpfung aufgebaut.

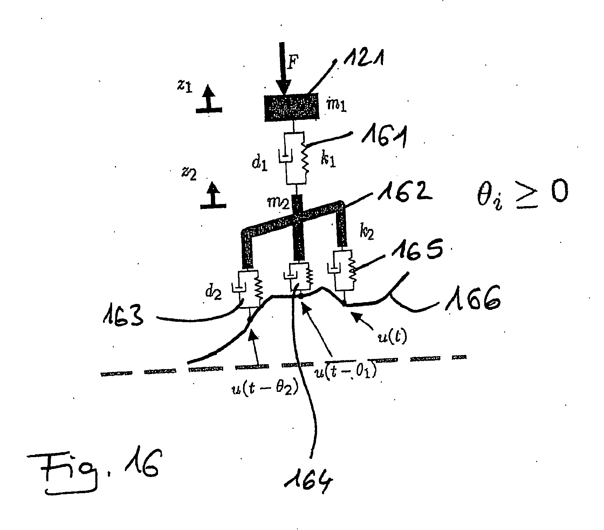

Figur 16 zeigt ein weiteres Beispiel einer translatorischen Komponente eines Reifen-Ersatzmodells, die besonders sinnvoll in vertikaler Richtung, also in Richtung der Straße, einsetzbar ist, da es den Reifenlatsch modeliert.

Wiederum weist das Ersatzmodell eine mit einer Nabe des Kraftfahrzeugs verbundene Masse 121 auf, die über ein elastisches Element 161 mit einer weiteren Masse 162 gekoppelt ist. Die Masse 162 ist nun über drei parallel zueinander wirkende elastische Elemente 163, 164 und 165 an ein Anregungsprofil 166 angekoppelt. Wird nun das elastische Element 165 zu einem Zeitpunkt t mit dem Anregungsprofil u(t) beaufschlagt, so wird das benachbarte elastische Element 164 zu diesem Zeitpunkt mit einem Wert $u(t-\theta_1)$ und das elastische Element 163 mit einem Wert $u(t-\theta_2)$ beaufschlagt. Zu einem gegebenen Zeitpunkt t wirken auf die elastischen Elemente 163, 164 und 165 also zeitlich verschobene Punkte des Anregungsprofils U, wobei die zeitliche Verschiebung gerade jener zeitliche Abstand ist, in dem das Fahrzeug der Simulation den Abstand zwischen den entsprechenden elastischen Elementen zurücklegt. Versteht man das Anregungsprofil U also als Straße, so koppeln die drei parallelen elastischen Elemente 163, 164 und 165 an hintereinander angeordnete Punkte der Straße gleichzeitig, was den Reifenlatsch simuliert.

Die drei Kräfte und Momente sind gerade die Kräfte und Momente, die vom Reifenmodell auf die Fahrzeugnabe übertragen werden. Das bedeutet: Der sechsdimensionale Zwei-Massen-Schwinger, der oben (teilweise) skizziert wurde, wird mit der Fahrzeugnabe verbunden, indem die obere Masse 121 fix mit der Fahrzeugnabe verbunden wird (starres Gelenk, "Fix-Joint"). Durch diese Kopplung entstehen entsprechend drei (Zwangs-)Kräfte und drei (Zwangs-)Momente, die also in diesem Sinne auf die Nabe des Reifenmodells aufgebracht werden.

Im Folgenden soll beispielhaft für einen eindimensionalen Zwei-Massen-Schwinger gezeigt werden, wie aus an der Nabe gemessenen Kräften, Momenten und Verschiebungen ein Anregungsprofil berechnet werden kann.

Die Parameter des eindimensionalen Zwei-Massen-Schwingers sind:

- die Massen $m_1$, $m_2$ des Zwei-Massen-Schwingers,
- Steifigkeiten bzw. Federkonstanten $k_1$, $k_2$ der elastischen Elemente,
- Dämpfungskonstanten $d_1$, $d_2$ der elastischen Elemente.

Dieser Parametersatz existiert für jeden der sechs Zwei-Massen-Schwinger entsprechend. Für die rotatorischen Drehfedern hat man die entsprechenden Trägheitsmomente anstelle der Massen.

Grundlage der Berechnung des Anregungsprofils sind die Bewegungsgleichungen des sechsdimensionalen 2-Massen-Schwingers. Zur übersichtlicheren Notation werden hier die Koordinaten entsprechend der sechs Freiheitsgrade von oberer $m_1$ und unterer Masse $m_2$ in den verallgemeinerten Koordinatenvektoren $q_1$ bzw. $q_2$ zusammen gefasst, d.h.

$$q_1 = (x_1, y_1, z_1, \alpha_1, \beta_1, \gamma_1),$$
$$q_2 = (x_2, y_2, z_2, \alpha_2, \beta_2, \gamma_2).$$

$$(1.2)$$

Die Winkel sind z.B. Kardan-Winkel.

Damit lauten die Bewegungsgleichungen

$$M(q_1, q_2)\begin{bmatrix} \ddot{q}_1 \\ \ddot{q}_2 \end{bmatrix} = \begin{bmatrix} F_{12}(q_1, q_2, \dot{q}_1, \dot{q}_2) + F_{NABE} \\ -F_{12}(q_1, q_2, \dot{q}_1, \dot{q}_2) + F_S(U) \end{bmatrix}$$

$$(1.3)$$

Darin sind

9

- $F_{12}(\cdot) \in R^6$ die (6D-) Feder-Dämpfer-Kräfte und - Momente,

- $F_{NABE} = (F_{NABE,x}, F_{NABE,y}, F_{NABE,z}, M_{NABE,x}, M_{NABE,y}, M_{NABE,z}) \in {}^6$
  sind die Zwangs- oder Schnitt-Kräfte und -Momente wie oben beschrieben,

- $F_5(U) \in {}^6$ ist die Kraft, die von der unteren Feder erzeugt wird und vom 6D-Anregungsprofil abhängt. U ist wie oben definiert dieses Anregungsprofil in sechs Dimensionen,

- $M(q_1,q_2) \in {}^{12\times12}$ ist die 12x12-Massenmatrix.

Zur Ermittlung des Anregungsprofils wird jetzt vorausgesetzt, dass

- die Nabenkräfte und -momente, d.h. $F_{NABE}$, bekannt sind und
- die Bewegung, d.h. die Verschiebungen und Verdrehungen der oberen Masse bekannt sind. Diese werden mit $q_{1REF}$ bezeichnet.

Nun wird das Anregungsprofil U so berechnet, dass bei der Lösung der obigen Bewegungsgleichungen diese Bewegung der oberen Masse möglichst gut reproduziert wird, d.h. man fordert

$$\int_0^T \left\| q_1 - q_{1,REF} \right\|^2 dt \to \text{ min,} \qquad (1.4)$$

wobei die Variable $q_1$ Teil der Lösung der Bewegungsgleichung (1.3) ist. T ist dabei der betrachtete Zeithorizont.
Es handelt sich hier um ein allgemeines Optimalsteuerungsproblem, in dem die Funktion $t \to U(t)$ die Unbekannte ist. Numerisch löst man solche Probleme, indem man z.B. das betrachtete Zeit-Intervall diskretisiert und für U auf den entstehenden Zeitabschnitten Ansatzfunktionen so wählt, dass die gesuchte $t \to U(t)$ durch endlich viele Koeffizienten eindeutig bestimmt ist. Man macht also einen Ansatz

$$U(t) = \sum_{i=1}^N u_i \cdot s_i(t)$$

$$(1.5)$$

wobei die $u_i \in {}^6$, die (noch) unbekannten Koeffizienten sind. Die Funktionen $t \to s_i(t)$ sind bekannte Ansatz-Funktionen, z.B. Splines.
Es ergibt sich damit ein endlich-dimensionales Optimierungsproblem. Unbekannte sind die Koeffizienten, $u_i$, i=1, ........., N, die $t \to U(t)$ bestimmen. Das endlichdimensionale Optimierungsproblem kann z.B. mit SQP-Verfahren gelöst werden. Eine detailliertere Darstellung der eben beschriebenen Vorgehensweise findet sich z.B. in M. Gerdts, "Direct shooting method for the numerical solution of higher-index dae optimal control problems", Journal of Optimization Theory and Applications, 117(2), S. 267-294, 2003 und M. Gerdts, "Optimal control and real-time optimization of mechanical multi-body systems", Z. Angew. Math. Mech., 83:705719, 2003.
Die Methode der Control-Constraints (W. Blajer and K. Kolodziejczyk, "A geometric approach to solving problems of control constraints: Theory and a dae framework", Multibody Syst Dyn, 11, S. 343-364, 2004), oder auch trajectory prescribed path control (K. E. Brenan, S. Campbell, and L. R. Petzold, "Numerical Solution of Initial-Value Problems in Differential-Algebraic Equations", volume 14 of Classics in Applied Mathematics, SIAM, 1996) ist nun eine Alternative zu der gerade beschriebenen allgemeinen Vorgehensweise, um das Optimalsteuerungsproblem zu lösen. Man fordert hier, dass die Referenz-Signale exakt reproduziert werden, d.h. dass gilt

$$q_1 - q_{1,REF} = 0. \qquad (1.6)$$

Gilt dies, ist natürlich auch die allgemeine Minimumsbedingung (1.4) erfüllt. Die Methode sieht nun vor, dass diese Bedingung als algebraische Gleichung der Bewegungsgleichung hinzugefügt wird. Es resultiert folgendes Gleichungssystem:

$$M(q_1, q_2)\begin{bmatrix} \ddot{q}_1 \\ \ddot{q}_2 \end{bmatrix} = \begin{bmatrix} F_{12}(q_1, q_2, \dot{q}_1, \dot{q}_2) + F_{NABE} \\ -F_{12}(q_1, q_2, \dot{q}_1, \dot{q}_2) + F_S(U) \end{bmatrix}$$

$$0 = q_1 - q_{1,REF}$$

$$(1.7)$$

Dies ist eine sog. Differential-Algebraische Gleichung (DAE) in den Unbekannten ($q_1$, $q_2$, U). Die numerische Lösung dieser DAE liefert also u.a. das gesuchte U.

Vorteil der Methode der Control-Constraints gegenüber dem zuvor beschriebenen allgemeineren Vorgehen ist das exakte Reproduzieren. Dafür hat man hier im Gegenzug keinerlei Möglichkeiten, Bedingungen an das zu bestimmende U zu stellen (z.B. keine zu hohe Rauhigkeit). Zusätzlich kann die DAE (1.7) u.U. numerisch sehr schwierig zu lösen sein (hoher Index).

**Patentansprüche**

1.  Verfahren zur Erzeugung eines Anregungsprofils, das einen zeitlichen Verlauf von auf einen Reifen eines Kraftfahrzeuges wirkenden mechanischen Größen nachbildet, die eine Kraft- und/oder Momentwirkung des Reifens auf eine Nabe des Kraftfahrzeuges verursachen,
    wobei aus dem Anregungsprofil mittels eines Ersatz-Modells des Reifens der zeitliche Verlauf zumindest einer Kraft und/oder zumindest eines Momentes zur Wirkung auf die Nabe bestimmbar ist,
    wobei das Anregungsprofil erzeugt wird, indem ein zeitlicher Verlauf der Kraft- und/oder Momentwirkung des mit der Nabe verbundenen Reifens auf die Nabe bei Wirkung der mechanischen Größen auf den Reifen gemessen und/oder simuliert wird, und
    aus dem gemessenen oder simulierten zeitlichen Verlauf der Kraft- und/oder Momentwirkung des Reifens auf die Nabe ein zeitlicher Verlauf der auf den Reifen wirkenden mechanischen Größen als Anregungsprofil ermittelt wird.

2.  Verfahren nach dem vorhergehenden Anspruch,
    **dadurch gekennzeichnet, dass** die auf den Reifen wirkenden mechanischen Größen, vorzugsweise mittels eines Optimalsteuerungsalgorithmuses, eines direkten Optimalsteuerungsalgorithmuses oder einer Methode der Control-Constraints, so ermittelt werden, dass, wenn das Ersatz-Modell auf das Anregungsprofil angewandt wird, das Ersatz-Modell einen zeitlichen Verlauf von Kräften und/oder Momenten auf die Nabe ergibt, der mit dem gemessenen Verlauf optimal übereinstimmt.

3.  Verfahren nach einem der vorhergehenden Ansprüche, **dadurch gekennzeichnet, dass** die mechanischen Größen auf den Reifen wirkende Kräfte und/oder Momente und/oder Auslenkungen des Reifens und/oder der Nabe sind.

4.  Verfahren zur zeitabhängigen Bereitstellung zumindest einer Kraft und/oder zumindest eines Momentes zur Wirkung auf eine Nabe eines Kraftfahrzeuges anstelle der Kraft- und/oder Momentwirkung eines mit der Nabe verbindbaren Reifens, wobei der zeitabhängige Verlauf der zumindest einen Kraft und/oder des zumindest einen Moments mit einem Ersatz-Modell des Reifens bestimmt wird, das aus einem in einem Verfahren nach einem der vorhergehenden Ansprüche erzeugten Anregungsprofil die zumindest eine Kraft und/oder das zumindest eine Moment erzeugt.

5.  Verfahren nach dem vorhergehenden Anspruch,
    **dadurch gekennzeichnet, dass** die Bereitstellung eine Erzeugung der zumindest einen Kraft und/oder des zumindest einen Momentes in einem Prüfstand für das Kraftfahrzeug ist, und/oder dass die Bereitstellung eine Berechnung der Werte der zumindest einen Kraft und/oder des zumindest einen Momentes für eine Simulation des Kraftfahrzeuges ist.

6.  Verfahren nach einem der vorhergehenden Ansprüche,

**dadurch gekennzeichnet, dass** die auf die Nabe wirkenden Kräfte und/oder Momente drei Translationsanteile und drei Rotationsanteile haben.

7. Verfahren nach einem der vorhergehenden Ansprüche,
**dadurch gekennzeichnet, dass** das Ersatz-Modell ein mechanisches Mehrkörpersystem aufweist, das mit der Nabe gekoppelt wird.

8. Verfahren nach dem vorhergehenden Anspruch, **dadurch gekennzeichnet, dass** das mechanische Mehrkörpersystem für jeden Freiheitsgrad des ErsatzModelles einen Mehr-Massen-Schwinger aufweist, der zwei oder mehr Massen aufweist, die über jeweils ein elastisches Element miteinander verbunden sind, und der vorzugsweise jeweils mit einer Masse fest mit der Nabe verbunden ist.

9. Verfahren nach dem vorhergehenden Anspruch, **dadurch gekennzeichnet, dass** zumindest eines der elastischen Elemente eine Feder und ein Dämpfungselement aufweisen, die vorzugsweise parallel zueinander wirkend angeordnet sind.

10. Verfahren nach einem der Ansprüche 8 oder 9, **dadurch gekennzeichnet, dass** der Mehr-Massen-Schwinger eine die Nabe ringförmig umgebende Masse aufweist, die mit der Nabe über zumindest zwei elastische Elemente verbunden ist, die vorzugsweise senkrecht zueinander wirken.

11. Verfahren nach einem der Ansprüche 8 oder 9, **dadurch gekennzeichnet, dass** der Mehr-Massen-Schwinger zwei, drei oder mehr parallel wirkende elastische Elemente aufweist, und dass die durch das Anregungsprofil gegebenen mechanischen Größen auf die parallel wirkenden elastischen Elemente jeweils um eine Zeit versetzt wirken.

6D
Anregungsprofil

Regler

6D
Reifen-
ersatzmodell

Regler

Reales
Fahrzeug/Achse
(nabengekoppelt)

inverses
6D Reifen-
ersatzmodell

Fig. 1

*Fig. 2*

31

Virtuelle Messung:

*AutoRef*

32

Radkraefte/-Momente
+ Nabenbewegung

33

Berechne U

34

*AutoRef*

Ankopplung
von (REM,U)

35

*AutoVar*

Vergleich

Virtuelle Messung:

*AutoVar*

36

Fig. 3

Fig. 4

Nabenmomente am
linken Vorderrad

$M_x$ [Nm]

Simuliert mit I6D
Referenz Virtuelle Messung

Zeit [s]

$M_y$ [Nm]

Simuliert mit I6D
Referenz Virtuelle Messung

Zeit [s]

$M_z$ [Nm]

Simuliert mit I6D
Referenz Virtuelle Messung

Zeit [s]

Fig. 5

Nabenkräfte am linken Vorderrad AutoVar1

Fig. 6

18

Nabenmomente am
linken Vorderrad
AutoVar1

Fig. 7

EP 2 450 814 A2

Nabenkräfte am
linken Vorderrad
AutoVar2

Fig. 8

EP 2 450 814 A2

Nabenmomente am
linken Vorderrad
AutoVar2

$5 \times 10^5$

Simuliert mit I6D
Referenz Virtuelle Messung

$M_x$ [Nm]

Zeit [s]

Simuliert mit I6D
Referenz Virtuelle Messung

$M_y$ [Nm]

Zeit [s]

$1 \times 10^5$

Simuliert mit I6D
Referenz Virtuelle Messung

$M_z$ [Nm]

Zeit [s]

Fig. 9

Nabenkräfte am
linken Vorderrad
AutoVar3

Fig. 10

Nabenmomente am
linken Vorderrad
AutoVar3

EP 2 450 814 A2

Fig. 11

EP 2 450 814 A2

$F$

$z_1$

121

$m_1$

123

$d_1$   $k_1$

122

$m_2$

124

$d_2$   $k_2$   126

127

125

$u_z(t)$

Fig. 12

Fig. 13

Fig. 14

Fig. 15

Fig. 16

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **M. GERDTS.** Direct shooting method for the numerical solution of higher-index dae optimal control problems. *Journal of Optimization Theory and Applications,* 2003, vol. 117 (2), 267-294
- **M. GERDTS.** Optimal control and real-time optimization of mechanical multi-body systems. *Z. Angew. Math. Mech.,* 2003, vol. 83, 705719

- **W. BLAJER ; K. KOLODZIEJCZYK.** A geometric approach to solving problems of control constraints: Theory and a dae framework. *Multibody Syst Dyn,* 2004, vol. 11, 343-364
- **K. E. BRENAN ; S. CAMPBELL ; L. R. PETZOLD.** Numerical Solution of Initial-Value Problems in Differential-Algebraic Equations. *Classics in Applied Mathematics, SIAM,* 1996, vol. 14